# EUROPEAN PATENT APPLICATION

(11) **EP 4 723 399 A1**
(43) Date of publication of application: **08.04.2026**
(21) Application number: 24810739.3
(22) Date of filing: 08.04.2024
(51) Int. Cl.: H01S 3/00, H01S 3/067, H01S 3/10, H01S 3/23

(54) **FIBER LASER, EXCITATION LIGHT SOURCE UNIT, AND METHOD FOR CONTROLLING FIBER LASER**

(30) Priority: 25.05.2023 JP 2023086284
(71) Applicant: Fujikura Ltd., Tokyo 135-8512 (JP)
(72) Inventor: YAMAMOTO, Tatsuya, Sakura-shi, Chiba 285-8550 (JP); NAGAOKA, Ryuji, Kobe-shi, Hyogo 650-8670 (JP)
(74) Representative: Plasseraud IP
(86) International application number: PCT/JP2024/014234
(87) International publication number: WO 2024/241731

(57) **Abstract**

Provided is a fiber laser and the like in which occurrence of a giant pulse is suppressed. A fiber laser (1) includes an MO section (11), a PA section (12), a voltage detection section (12b3), and a control section (12b2). The PA section (12) includes an optical fiber (12a), a pumping light source (LD), a capacitor (C), and a switch (SW2). The voltage detection section (12b3) detects a voltage of a direct-current power supply (PS) which supplies an electric current to the MO section (11) and the pumping light source (LD). The control section (12b2) carries out control to open the switch (SW2) in response to a transition from a state where the voltage detected by the voltage detection section (12b3) is higher than a predetermined threshold to a state where that voltage is lower than the threshold.

## Description

### Technical Field

The present invention relates to a fiber laser including a Master Oscillator (MO) section and a Power Amplifier (PA) section. The present invention further relates to an excitation light (pumping light) source unit for use in such a fiber laser. The present invention further relates to a method for controlling such a fiber laser.

### Background Art

A Master Oscillator - Power Amplifier (MOPA) type fiber laser is widely used as a high output fiber laser for, e.g., laser processing. For example, Patent Literature 1 is a literature disclosing the MOPA type fiber laser.

### Citation List

### Patent Literatures

Patent Literature 1
Japanese Patent Application Publication, Tokukai, No. 2012-84630

### Summary of Invention

### Technical Problem

In the MOPA type fiber laser, a laser beam generated by the MO section is amplified by the PA section, so that a high-intensity laser beam is obtained. The PA section can be a fiber amplifier including an optical fiber doped with a rare earth element and a pumping light source which generates pumping light for exciting the rare earth element. In the PA section, the amplification of the laser beam is realized by stimulated emission of the rare earth element which is excited by the pumping light.

In making an emergency stop of the MOPA type fiber laser, the supply of the laser beam from the MO section to the PA section may sometimes be stopped before the supply of the pumping light from the pumping light source of the PA section to the rare earth element is stopped. In such a case, an energy of the pumping light would not be consumed for the amplification of the laser beam, but would be accumulated in the rare earth element. In the state where the energy of the pumping light is accumulated in the rare earth element, the stimulated emission of the rare earth element may sometimes occur one after another in chain explosively in response to noise and/or the like. In such a case, ultra-high peak power pulsed light will be output from the PA section. The ultra-high peak power pulsed light output from the PA section in this manner is called a "giant pulse", which can be a factor of damaging, e.g., an optical component(s) existing in its surroundings.

An aspect of the present invention was made in light of the above-described problem, and has an object to provide a fiber laser and the like in which occurrence of a giant pulse is suppressed.

### Solution to Problem

A fiber laser in accordance with an aspect of the present invention includes: a Master Oscillator section; a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided within a closed electric current path including the pumping light source and the capacitor, the Power Amplifier section amplifying a laser beam generated by the Master Oscillator section by using the optical fiber; a voltage detection section which detects a voltage of a direct-current power supply which supplies an electric current to the Master Oscillator section and the pumping light source; and a control section which carries out control to open the switch in response to a transition from (i) a state where the voltage detected by the voltage detection section is higher than a predetermined threshold to (ii) a state where the voltage detected by the voltage detection section is lower than the predetermined threshold.

A pumping light source unit in accordance with an aspect of the present invention is a pumping light source unit for use in a fiber amplifier including an optical fiber doped with a rare earth element, the pumping light source unit including: a pumping light source which generates pumping light for exciting the rare earth element; a capacitor which is connected in parallel with the pumping light source; a switch which is provided on an electric current path between the pumping light source and the capacitor; a voltage detection section which detects a voltage of a direct-current power supply which supplies an electric current to the pumping light source; and a control section which carries out control to open the switch in response to a transition from (i) a state where the voltage detected by the voltage detection section is higher than a predetermined threshold to (ii) a state where the voltage detected by the voltage detection section is lower than the predetermined threshold.

A method, in accordance with an aspect of the present invention, for controlling a fiber laser is a method for controlling a fiber laser that includes a Master Oscillator section and a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided on an electric current path between the pumping light source and the capacitor, the Power Amplifier section amplifying a laser beam generated by the Master Oscillator section by using the optical fiber, the method including: a voltage detection step of detecting a voltage of a direct-current power supply which supplies an electric current to the Master Oscillator section and the pumping light source; and a control step of carrying out control to open the switch in response to a transition from (i) a state where the voltage detected by the voltage detection section is higher than a predetermined threshold to (ii) a state where the voltage detected by the voltage detection section is lower than the predetermined threshold.

### Advantageous Effects of Invention

In accordance with an aspect of the present invention, it is possible to suppress occurrence of a giant pulse.

### Brief Description of Drawings

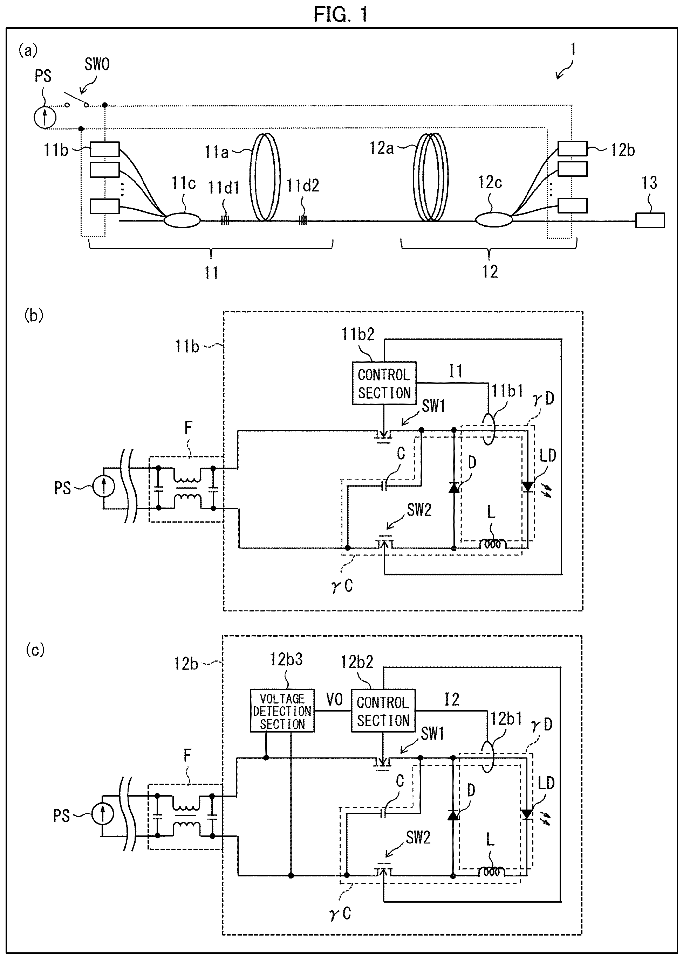

(a) of Fig. 1 is a view schematically illustrating a configuration of a fiber laser in accordance with an embodiment of the present invention. (b) of Fig. 1 is a circuit diagram illustrating a configuration of a pumping light source unit included in an MO section of the fiber laser. (c) of Fig. 1 is a circuit diagram illustrating a configuration of a pumping light source unit included in a PA section of the fiber laser.
Fig. 2 shows an effect of the fiber laser illustrated in Fig. 1. (a) of Fig. 2 is a graph illustrating time-series changes of a power supply voltage of a direct-current power supply. (b) of Fig. 2 is a graph illustrating time-series changes of a driving current of a laser diode.
Fig. 3 illustrates variations of the fiber laser illustrated in Fig. 1. (a) of Fig. 3 is a circuit diagram illustrating a first variation of the pumping light source unit of the PA section. (b) of Fig. 3 is a circuit diagram illustrating a second variation of the pumping light source unit of the PA section. (c) of Fig. 3 is a circuit diagram illustrating a third variation of the pumping light source unit of the PA section.
Fig. 4 illustrates variations of the fiber laser illustrated in Fig. 1. (a) of Fig. 4 is a view schematically illustrating a first variation of the MO section. (b) of Fig. 4 is a view schematically illustrating a second variation of the MO section.
Fig. 5 illustrates variations of the fiber laser illustrated in Fig. 1. (a) of Fig. 5 is a view schematically illustrating a first variation of the PA section. (b) of Fig. 5 is a view schematically illustrating a second variation of the PA section.

### Description of Embodiments

### Configuration of Fiber Laser

The following will describe, with reference to (a) of Fig. 1, a fiber laser 1 in accordance with an embodiment of the present invention. (a) of Fig. 1 is a view schematically illustrating a configuration of the fiber laser 1.

The fiber laser 1 is a Master Oscillator - Power Amplifier (MOPA) type fiber laser for processing, and includes a Master Oscillator (MO) section 11, a Power Amplifier (PA) section 12 which amplifies a laser beam generated by the MO section 11, and a processing head 13. Note that the processing head 13 can be exchanged with another one depending on its intended use or can be omitted.

In the present embodiment, a forward pumping fiber laser is used as the MO section 11. As illustrated in (a) of Fig. 1, for example, the MO section 11 includes an optical fiber 11a, a pumping light source unit 11b, a combiner 11c, and a pair of Fiber Bragg Gratings (FBGs) 11d1 and 11d2. As illustrated in (a) of Fig. 1, the number of pumping light source units 11b may be two or more.

The optical fiber 11a is an optical fiber including a core doped with a rare earth element (for example, a double cladding fiber). There is no particular limitation on the rare earth element with which the core of the optical fiber 11a is doped. In the present embodiment, Yb is used as the rare earth element. One end of the optical fiber 11a is connected with the FBG 11d1 serving as a mirror, and the other end of the optical fiber 11a is connected with the FBG 11d2 serving as a half mirror. With this, the optical fiber 11a functions as an oscillator that recursively amplifies a laser beam discharged from the rare earth element which is excited.

The pumping light source unit 11b is configured to generate pumping light (forward pumping light) for exciting the rare earth element with which the core of the optical fiber 11a is doped. There is no particular limitation on the pumping light source that generates pumping light. In the present embodiment, a Laser Diode (LD) is used as the pumping light source. The configuration of the pumping light source unit 11b will be described later with reference to (b) of Fig. 1. The pumping light generated by the pumping light source unit 11b is introduced into an inner cladding of the optical fiber 11 by the combiner 11c.

In the present embodiment, a backward pumping fiber amplifier is used as the PA section 12. As illustrated in (a) of Fig. 1, the PA section 12 can be constituted by an optical fiber 12a, a pumping light source unit 12b, and a combiner 12c, for example. As illustrated in (a) of Fig. 1, the number of pumping light source units 12b may be two or more.

The optical fiber 12a is an optical fiber including a core doped with a rare earth element (for example, a double cladding fiber). There is no particular limitation on the rare earth element with which the core of the optical fiber 12a is doped. In the present embodiment, Yb is used as the rare earth element. One end of the optical fiber 12a is connected with the FBG 11d2 of the MO section 11. With this, the optical fiber 12a functions as an amplifier that amplifies a laser beam generated by the MO section 11. The other end of the optical fiber 12a is connected with the processing head 13. With this, the laser amplified by the optical fiber 12a is emitted to a work piece via the processing head 13.

The pumping light source unit 12b is configured to generate pumping light (backward pumping light) for exciting the rare earth element with which the core of the optical fiber 12a is doped. There is no particular limitation on the pumping light source that generates pumping light. In the present embodiment, an LD is used as the pumping light source. The configuration of the pumping light source unit 12b will be described later with reference to (c) of Fig. 1. The pumping light generated by the pumping light source unit 12b is introduced into an inner cladding of the optical fiber 12 by the combiner 12c.

The pumping light source unit 11b of the MO section 11 and the pumping light source unit 12b of the PA section 12 are operated by an electric current supplied by a common direct-current power supply PS (for example, an alternating current (AC) - direct current (DC) converter connected with an alternating-current power supply such as a commercial power supply). A switch SW0 is provided on an electric current path between the direct-current power supply PS and the pumping light source units 11b and 12b. The switch SW0 is, for example, an emergency stop switch used to make an emergency stop of operation of the fiber laser 1 when some kind of abnormality occurs in the fiber laser 1. In the present embodiment, a relay switch is used as the switch SW0.

When the switch SW0 is opened, the supply of the electric current to the pumping light source units 11b and 12b is stopped. Consequently, the supply of the pumping light to the optical fibers 11a and 12a is stopped. During this, if the supply of the pumping light to the optical fiber 11a in the MO section 11 is stopped before the supply of the pumping light to the optical fiber 12a in the PA section 12 is stopped, there is a risk of occurrence of a giant pulse in the PA section 12. In order to deal with this, in the fiber laser 1 in accordance with the present embodiment, the pumping light source unit 12b is devised such that the supply of the pumping light to the optical fiber 12a in the PA section 12 is stopped before the supply of the pumping light to the optical fiber 11a in the MO section 11 is stopped.

### Configuration of Pumping Light Source Unit of MO Section

The following will describe, with reference to (b) of Fig. 1, a configuration of the pumping light source unit 11b of the MO section 11. (b) of Fig. 1 is a circuit diagram illustrating a configuration of the pumping light source unit 11b of the MO section 11.

The pumping light source unit 11b is constituted by a laser diode LD which generates pumping light and a driving circuit which drives the laser diode LD. For example, as illustrated in (b) of Fig. 1, the driving circuit may be constituted by a diode D, a capacitor C, an inductor L, a switch SW1 (one example of the "positive electrode-side switch" recited in the claims), a switch SW2 (one example of the "negative electrode-side switch" recited in the claims), an electric current detection section 11b1, and a control section 11b2.

The diode D and the capacitor C are connected in parallel with the laser diode LD. The laser diode LD is oriented so that an anode thereof is connected with a positive electrode-side of the direct-current power supply PS and a cathode thereof is connected with a negative electrode-side of the direct-current power supply PS. The diode D is oriented so that a cathode thereof is connected with the positive electrode-side of the direct-current power supply PS and an anode thereof is connected with the negative electrode-side of the direct-current power supply PS.

The switches SW1 and SW2 and the inductor L are connected in series with the laser diode LD. The switch SW1 is positioned outside a closed electric current path γD including the laser diode LD and the diode D and outside a closed electric current path yC including the laser diode LD and the capacitor C. The switch SW2 is positioned outside the closed electric current path yD including the laser diode LD and the diode D and inside the closed electric current path yC including the laser diode LD and the capacitor C. The inductor L is positioned inside the closed electric current path yD including the laser diode LD and the diode D and inside the closed electric current path yC including the laser diode LD and the capacitor C. In the present embodiment, Field Effect Transistors (FETs) are used as the switches SW1 and SW2.

The electric current detection section 11b1 detects an electric current flowing into the laser diode LD (hereinafter, such an electric current will be referred to as a "driving current I1"). During general operation, the control section 11b2 keeps the switch SW1 closed, and carries out control to open or close the switch SW2 in accordance with a magnitude of the driving current I1. To be more specific, the control section 11b2 (1) carries out control to open the switch SW2 when the driving current I1 becomes higher than a predetermined threshold Th1, and (2) carries out control to close the switch SW2 when the driving current I1 becomes lower than the threshold Th1. With this, while the switch SW0 illustrated in (a) of Fig. 1 is opened by control, the laser diode LD is constantly supplied with the driving current I1 which is identical to or close to the threshold Th1.

When the switch SW0 is opened at the time of an emergency stop, the supply of the electric current to the pumping light source unit 11b is stopped. Note, however, that the driving current I1 is continuously supplied to the laser diode LD, as long as the switch SW2 is closed. This happens because electric charges having been accumulated in the capacitor C flow into the laser diode LD. Further, in a case where a filter F disposed between the pumping light source unit 11b and the direct-current power supply PS includes a capacitor connected in parallel with the laser diode LD as shown in (b) of Fig. 1, the electric charges having been accumulated in these capacitors also flow into the laser diode LD while the switches SW1 and SW2 are closed. Note that the filter F is not essential and may be omitted.

### Configuration of Pumping Light Source Unit of PA Section

The following will describe, with reference to (c) of Fig. 1, a configuration of the pumping light source unit 12b of the PA section 12. (c) of Fig. 1 is a circuit diagram illustrating a configuration of the pumping light source unit 12b of the PA section 12.

The pumping light source unit 12b is constituted by a laser diode LD which generates pumping light and a driving circuit which drives the laser diode LD. A configuration of the driving circuit of the pumping light source unit 12b is identical to the configuration of the driving circuit of the pumping light source unit 11b illustrated in (b) of Fig. 1, except that the driving circuit of the pumping light source unit 12b additionally includes a voltage detection section 12b3.

Similarly to the electric current detection section 11b1, the electric current detection section 12b1 detects an electric current flowing into the laser diode LD (hereinafter, referred to as a "driving current I2"). Similarly to the control section 11b2, during general operation, the control section 12b2 keeps the switch SW1 closed, and carries out control to open or close the switch SW2 in accordance with a magnitude of the driving current I2. To be more specific, the control section 12b2 (1) carries out control to open the switch SW2 when the driving current I2 becomes higher than a predetermined threshold Th2, and (2) carries out control to close the switch SW2 when the driving current I2 becomes lower than the threshold Th2. With this, while the switch SW0 illustrated in (a) of Fig. 1 is opened by control, the laser diode LD is constantly supplied with the driving current I2 which is identical to or close to the threshold Th1.

The voltage detection section 12b3 detects a voltage of the direct-current power supply PS (hereinafter, such a voltage will also be referred to as a "power supply voltage V0"). The control section 12b2 controls the switch SW2 in accordance with a magnitude of the power supply voltage V0. To be more specific, the control section 12b2 carries out control to open the switch SW2 in response to a transition from (i) a state where the power supply voltage V0 is higher than a predetermined threshold Th0 to (ii) a state where the power supply voltage V0 is lower than the threshold Th0.

Note here that a threshold Th is set at a value lower than a rated voltage of the direct-current power supply PS (for example, a value of approximately 85% of the rated voltage of the direct-current power supply PS). For example, in a case where the direct-current power supply PS has a rated voltage of 270V, the threshold Th is set at 230V. Thus, when the switch SW0 is opened at the time of an emergency stop, the switch SW2 is controlled to be opened immediately after that. Opening the switch SW2 prevents a phenomenon that electric charges having been accumulated in the capacitor C flow into the laser diode LD. Further, opening the switch SW2 prevents a phenomenon that electric charges having been accumulated in a capacitor included in the filter F flow into the laser diode LD. Consequently, a period of time between (i) a point of time when the supply of the electric current to the pumping light source unit 12b is stopped and (ii) a point of time when the supply of the driving current I2 to the laser diode LD of the pumping light source unit 12b is stopped is shorter than a period of time between (i) a point of time when the supply of the electric current to the pumping light source unit 11b is stopped and (ii) a point of time when the supply of the driving current I1 to the laser diode LD of the pumping light source unit 11b is stopped.

When the power supply voltage V0 becomes lower than the threshold Th0, the control section 12b2 may control both the switches SW1 and SW2 rather than only the switch SW2. With this, even in a case where a ground fault of the laser diode LD occurs or even in a case where the switch SW2 malfunctions, it is possible to prevent a phenomenon that electric charges having been accumulated in the capacitor included in the filter F flow into the laser diode LD. The switch SW1 can also be used for emergency shut-off carried out if an alarm is issued.

In the present embodiment, the voltage detection section 12b3 is provided inside the pumping light source unit 12b. However, the present invention is not limited to this. That is, the voltage detection section 12b3 may be provided outside the pumping light source unit 12b. In the present embodiment, the control section 12b2 provided inside the pumping light source unit 12b is caused to carry out control to open the switches SW1 and SW2 in accordance with the power supply voltage V0. However, the present invention is not limited to this. That is, a control section provided outside the pumping light source unit 12b, for example, a control section which controls the whole of the fiber laser is caused to carry out control to open the switches SW1 and SW2 in accordance with the power supply voltage V0.

### Effects of Fiber Laser

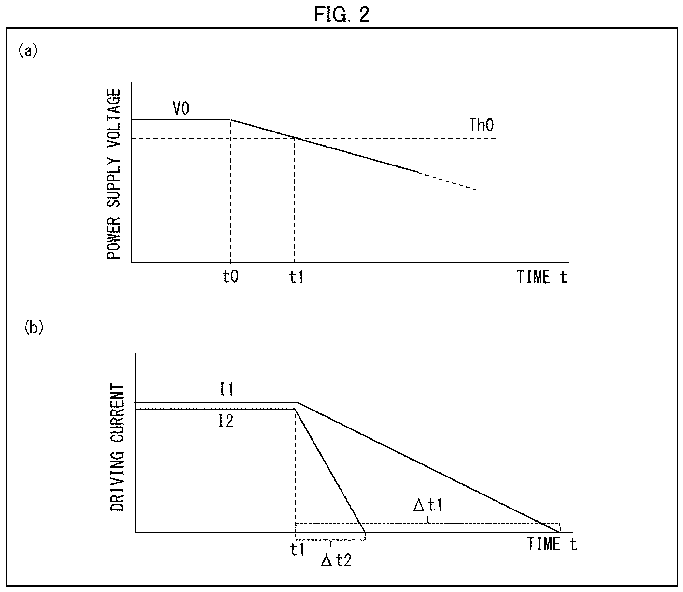

The following will describe, with reference to Fig. 2, effects of the fiber laser 1. In Fig. 2, (a) is a graph illustrating time-series changes of the power supply voltage V0 of the direct current PS, whereas (b) is a graph illustrating time-series changes of the driving current I1 supplied to the laser diode LD in the MO section 11 and the driving current I2 supplied to the laser diode LD in the PA section 12.

When the switch SW0 is opened by control at time t0, the power supply voltage V0 starts decreasing (see (a) of Fig. 2). Then, when a transition from the state where the power supply voltage V0 is higher than the threshold Th0 to the state where the power supply voltage V0 is lower than the threshold Th0 is made at time t1 (see (a) of Fig. 2), the control section 12b2 of the PA section 12 carries out control to open the switch SW2 (see (c) of Fig. 1).

In response to this, the driving current I2 supplied to the laser diode LD of the PA section 12 suddenly decreases (see (b) of Fig. 2). Meanwhile, the electric charges having been accumulated in the capacitor C continuously flow into the laser diode LD of the MO section 11 as the driving current I1. Therefore, the driving current I1 supplied to the laser diode LD of the MO section 11 decreases more slowly than the driving current I2 supplied to the laser diode LD of the PA section 12 (see (b) of Fig. 2).

A period of time Δt1 between (i) a point of time when the control section 12b2 of the PA section 12 carries out control to open the switch SW2 and (ii) a point of time when the supply of the driving current I1 to the laser diode LD of the MO section 11 is stopped is a period of time required to carry out electric discharge of the capacitor C. For example, the period of time Δt1 is not less than 1 ms. There is no particular limitation on an upper limit of the period of time Δ1. For example, the upper limit of the period of time Δ1 is 500 ms. Meanwhile, a period of time Δt2 between (i) a point of time when the control section 12b2 of the PA section 12 carries out control to open the switch SW2 and (ii) a point of time when the supply of the driving current I2 to the laser diode LD of the PA section 12 is stopped is a period of time required to carry out electric discharge of the inductor L. For example, the period of time Δt2 is not more than 100 µs. There is no particular limitation on a lower limit of the period of time Δt2. For example, the lower limit of the period of time Δt2 is 1 ns.

With this, it is possible to stop the supply of the pumping light from the pumping light source unit 12b of the PA section 12 to the optical fiber 12a of the PA section 12 before the supply of the laser beam from the optical fiber 11a of the MO section 11 to the optical fiber 12a of the PA section 12 is stopped. Therefore, it is possible to significantly reduce a possibility of occurrence of a giant pulse in the optical fiber 12a of the PA section 12.

### Variations of Pumping Light Source Unit of PA Section

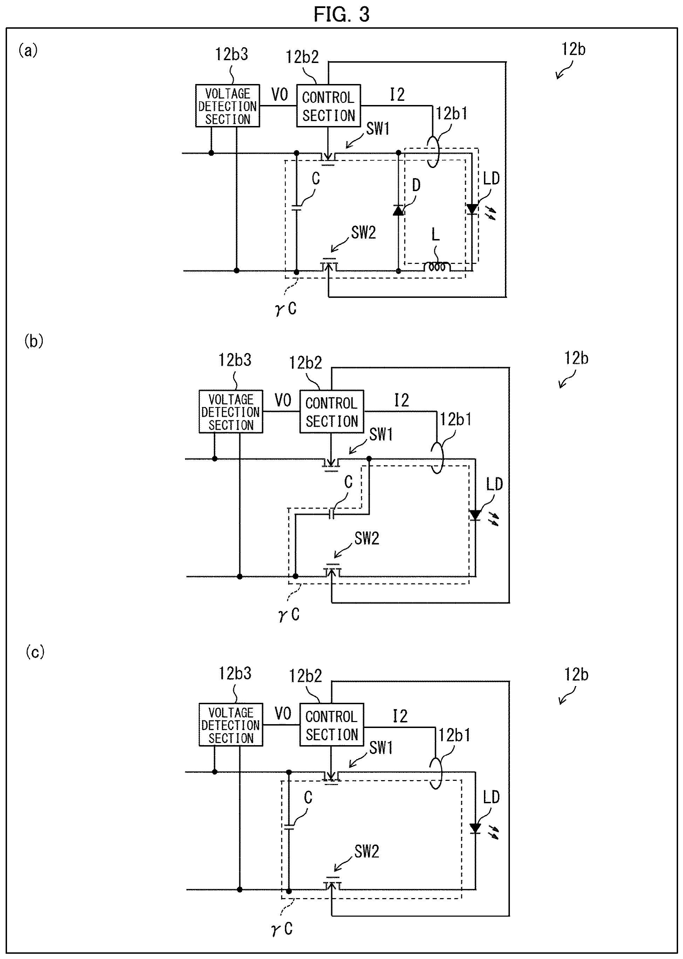

The following will describe, with reference to Fig. 3, variations of the pumping light source unit 12b of the PA section 12.

(a) of Fig. 3 is a circuit diagram illustrating a first variation of the pumping light source unit 12b.

The pumping light source unit 12b illustrated in (c) of Fig. 1 differs from a pumping light source unit 12b illustrated in (a) of Fig. 3 in the position of the switch SW1. That is, in the pumping light source unit 12b illustrated in (c) of Fig. 1, the switch SW1 is disposed outside the closed electric current path yC including the laser diode LD and the capacitor C. In contrast to this, in the pumping light source unit 12b illustrated in (a) of Fig. 3, a switch SW1 is disposed inside a closed electric current path yC including a laser diode LD and a capacitor C.

Thus, in the pumping light source unit 12b illustrated in (a) of Fig. 3, carrying out control to open at least one of the switches SW1 and SW2 makes it possible to prevent a phenomenon that electric charges having been accumulated in the capacitor C flow into the laser diode LD. If a configuration of carrying out control to open both the switches SW1 and SW2 is employed, it is possible to prevent a phenomenon that the electric charges having been accumulated in the capacitor C and capacitors included in a filter F flow into the laser diode LD, even in a case where a ground fault of the laser diode LD occurs or even in a case where the switch SW2 malfunctions.

(b) of Fig. 3 is a circuit diagram illustrating a second variation of the pumping light source unit 12b.

The pumping light source unit 12b illustrated in (c) of Fig. 1 differs from a pumping light source unit 12b illustrated in (b) of Fig. 3 in the following point. That is, the former includes a switching-type driving circuit, whereas the latter includes a linear-type driving circuit. Thus, in the pumping light source unit 12b illustrated in (b) of Fig. 3, the diode D and the inductor L are omitted. Further, during general operation, a control section 12b2 sets a resistance value for a switch SW2 (FET) by adjusting a gate voltage of the switch SW2 (FET) such that a driving current I2 becomes equal to a predetermined value.

Similarly to the pumping light source unit 12b illustrated in (c) of Fig. 1, the pumping light source unit 12b illustrated in (b) of Fig. 3 can prevent, by carrying out control to open the switch SW2, a phenomenon that electric charges having been accumulated in the capacitor C flow into the laser diode LD.

(c) of Fig. 3 is a circuit diagram illustrating a third variation of the pumping light source unit 12b.

The pumping light source unit 12b illustrated in (b) of Fig. 3 differs from a pumping light source unit 12b illustrated in (c) of Fig. 3 in the position of the switch SW1. That is, in the pumping light source unit 12b illustrated in (b) of Fig. 3, the switch SW1 is disposed outside the closed electric current path yC including the laser diode LD and the capacitor C. In contrast to this, in the pumping light source unit 12b illustrated in (c) of Fig. 3, a switch SW1 is disposed inside a closed electric current path yC including a laser diode LD and a capacitor C.

Thus, in the pumping light source unit 12b illustrated in (c) of Fig. 3, carrying out control to open at least one of the switches SW1 and SW2 makes it possible to prevent a phenomenon that electric charges having been accumulated in the capacitor C flow into the laser diode LD. By employing a configuration of controlling to open both the switches SW1 and SW2, it is possible to prevent a phenomenon that the electric charges having been accumulated in the capacitor C and capacitors included in a filter F flow into the laser diode LD, even in a case where a ground fault of the laser diode LD occurs or even in a case where the switch SW2 malfunctions.

The foregoing explanation has dealt with the three variations of the pumping light source unit 12b of the PA section 12. The pumping light source unit 11b of the MO section 11 can also be altered in a similar manner.

### Variations of MO Section

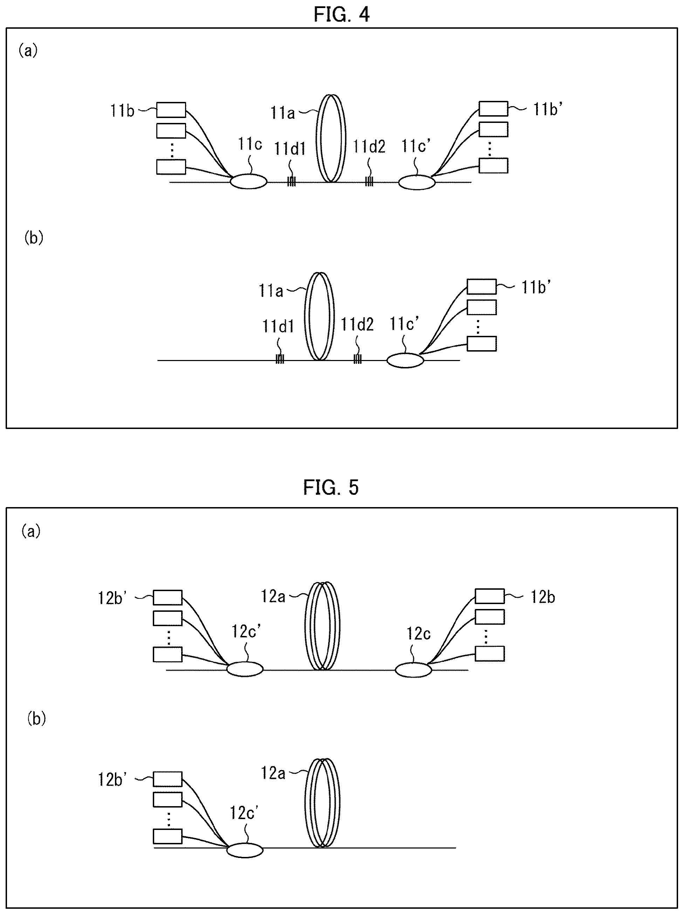

The following will describe, with reference to (a) of Fig. 4, a first variation of the MO section 11. (a) of Fig. 4 is a view schematically illustrating the first variation of the MO section 11.

An MO section 11 illustrated in (a) of Fig. 4 is a bidirectional pumping fiber laser which can be obtained by adding a pumping light source unit 11b' and a combiner 11c' to the MO section 11 illustrated in (a) of Fig. 1. Note here that the pumping light source unit 11b' is configured to generate pumping light (backward pumping light) for exciting the rare earth element with which the core of the optical fiber 11a is doped. Note also that the combiner 11c' is configured to introduce pumping light generated by the pumping light source unit 11b' into the inner cladding of the optical fiber 11a.

The following will describe, with reference to (b) of Fig. 4, a second variation of the MO section 11. (b) of Fig. 4 is a view schematically illustrating the second variation of the MO section 11.

The MO section 11 illustrated in (b) of Fig. 4 is a backward pumping fiber laser which can be obtained by replacing the pumping light source unit 11b and the combiner 11c of the MO section 11 illustrated in (a) of Fig. 1 with a pumping light source unit 11b' and a combiner 11c', respectively. Note here that the pumping light source unit 11b' is configured to generate pumping light (backward pumping light) for exciting the rare earth element with which the core of the optical fiber 11a is doped. Note also that the combiner 11c' is configured to introduce pumping light generated by the pumping light source unit 11b' into the inner cladding of the optical fiber 11a.

Note that the MO section 11 only needs to be a laser device which generates a laser beam (seed beam) supplied to the PA section 12, and does not need to be a fiber laser. As the MO section 11, it is possible to employ any laser device which can be driven by a direct-current power supply PS. Examples of such a laser device include a solid laser, a liquid laser, and a gas laser.

### Variations of PA section

The following will describe, with reference to (a) of Fig. 5, a first variation of the PA section 12. (a) of Fig. 5 is a view schematically illustrating the first variation of the PA section 12.

The PA section 12 illustrated in (a) of Fig. 5 is a bidirectional pumping fiber amplifier which can be obtained by adding a pumping light source unit 12b' and a combiner 12c' to the PA section 12 illustrated in (a) of Fig. 1. Note here that the pumping light source unit 12b' is configured to generate pumping light (forward pumping light) for exciting the rare earth element with which the core of the optical fiber 12a is doped. Note also that the combiner 12c' is configured to introduce pumping light generated by the pumping light source unit 12b' into the inner cladding of the optical fiber 12a.

The following will describe, with reference to (b) of Fig. 5, a second variation of the PA section 12. (b) of Fig. 5 is a view schematically illustrating the second variation of the PA section 12.

The PA section 12 illustrated in (b) of Fig. 5 is a forward pumping fiber laser which can be obtained by replacing the pumping light source unit 12b and the combiner 12c of the PA section 12 illustrated in (a) of Fig. 1 with a pumping light source unit 12b' and a combiner 12c', respectively. Note here that the pumping light source unit 12b' is configured to generate pumping light (forward pumping light) for exciting the rare earth element with which the core of the optical fiber 12a is doped. Note also that the combiner 12c' is configured to introduce pumping light generated by the pumping light source unit 12b' into the inner cladding of the optical fiber 12a.

### Supplemental Remarks

The present invention is not limited to the foregoing embodiments, but can be altered within the scope of the claims. The present invention also encompasses, in its technical scope, any embodiment derived by combining technical means disclosed in differing embodiments discussed above.

Aspects of the present invention can also be expressed as follows:
A fiber laser in accordance with a first aspect of the present invention includes: a Master Oscillator section; a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided within a closed electric current path including the pumping light source and the capacitor, the Power Amplifier section amplifying a laser beam generated by the Master Oscillator section by using the optical fiber; a voltage detection section which detects a voltage of a direct-current power supply which supplies an electric current to the Master Oscillator section and the pumping light source; and a control section which carries out control to open the switch in response to a transition from (i) a state where the voltage detected by the voltage detection section is higher than a predetermined threshold to (ii) a state where the voltage detected by the voltage detection section is lower than the predetermined threshold.

With the above configuration, it is possible to stop the supply of the pumping light from the pumping light source of the PA section to the rare earth element before the supply of the laser beam from the MO section to the PA section is stopped. As a result, it is possible to suppress occurrence of a giant pulse.

A fiber laser in accordance with a second aspect of the present invention employs, in addition to the configuration in accordance with the first aspect, a configuration in which: the Master Oscillator section includes (i) an optical fiber doped with a rare earth element, (ii) a pumping light source which generates pumping light for exciting the rare earth element, and (iii) a capacitor which is connected in parallel with the pumping light source; and the direct-current power supply supplies an electric current to both the pumping light source included in the Master Oscillator section and the pumping light source included in the Power Amplifier section.

With the above configuration, it is possible to more reliably stop the supply of the pumping light from the pumping light source of the PA section to the rare earth element before the supply of the laser beam from the MO section to the PA section is stopped. As a result, it is possible to more reliably suppress occurrence of a giant pulse.

A fiber laser in accordance with a third aspect of the present invention employs, in addition to the configuration in accordance with the second aspect, a configuration in which: a period of time between (i) a point of time when the switch is controlled to be opened and (ii) a point of time when the electric current supplied to the pumping light source included in the Power Amplifier section becomes 0A is not more than 100 µs; and a period of time between (i) a point of time when the switch is controlled to be opened and (ii) a point of time when the electric current supplied to the pumping light source included in the Master Oscillator section becomes 0A is not less than 1 ms.

With the above configuration, it is possible to even more reliably stop the supply of the pumping light from the pumping light source of the PA section to the rare earth element before the supply of the laser beam from the MO section to the PA section is stopped. As a result, it is possible to even more reliably suppress occurrence of a giant pulse.

A fiber laser in accordance with a fourth aspect of the present invention employs, in addition to any one of the configurations in accordance with the first to third aspects, a configuration in which: the switch is a negative electrode-side switch which is provided on an electric current path between a negative electrode of the direct-current power supply and the pumping light source included in the Master Oscillator section; and the control section carries out control to open the negative electrode-side switch in response to a transition from (i) a state where the voltage detected by the voltage detection section is higher than the threshold to (ii) a state where the voltage detected by the voltage detection section is lower than the threshold.

With the above configuration, the negative electrode-side switch, which is used for switching driving of the pumping light source during general operation, can be used to prevent a phenomenon that electric charges having been accumulated in the capacitor flow into the pumping light source at the time of an emergency stop.

A fiber laser in accordance with a fifth aspect of the present invention employs, in addition to any one of the configurations in accordance with the first to third aspects, a configuration in which: the switch includes a negative electrode-side switch which is provided on an electric current path between a negative electrode of the direct-current power supply and the pumping light source included in the Master Oscillator section and a positive electrode-side switch which is provided on an electric current path between a positive electrode of the direct-current power supply and the pumping light source included in the Master Oscillator section; and the control section carries out control to open both of the negative electrode-side switch and the positive electrode-side switch in response to a transition from (i) a state where the voltage detected by the voltage detection section is higher than the threshold to (ii) a state where the voltage detected by the voltage detection section is lower than the threshold.

With the above configuration, even in a case where the negative electrode-side switch malfunctions or even in a case where a ground fault of the pumping light source occurs, it is possible to prevent, by carrying out control to open the positive electrode-side switch, a phenomenon that electric charges having been accumulated in the capacitor flow into the pumping light source.

A fiber laser in accordance with a sixth aspect of the present invention employs, in addition to any one of the configurations in accordance with the first to fifth aspects, a configuration in which the switch is a Field Effect Transistor.

With the above configuration, it is possible to open or close the switch quickly.

A pumping light source unit in accordance with a seventh aspect of the present invention is a pumping light source unit for use in a fiber amplifier including an optical fiber doped with a rare earth element, the pumping light source unit including: a pumping light source which generates pumping light for exciting the rare earth element; a capacitor which is connected in parallel with the pumping light source; a switch which is provided on an electric current path between the pumping light source and the capacitor; a voltage detection section which detects a voltage of a direct-current power supply which supplies an electric current to the pumping light source; and a control section which carries out control to open the switch in response to a transition from (i) a state where the voltage detected by the voltage detection section is higher than a predetermined threshold to (ii) a state where the voltage detected by the voltage detection section is lower than the predetermined threshold.

With the above configuration, it is possible to stop the supply of the pumping light from the pumping light source of the fiber amplifier to the rare earth element before the supply of the laser beam to the fiber amplifier is stopped. As a result, it is possible to suppress occurrence of a giant pulse.

A method, in accordance with an eighth aspect of the present invention, for controlling a fiber laser is a method for controlling a fiber laser that includes a Master Oscillator section and a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided on an electric current path between the pumping light source and the capacitor, the Power Amplifier section amplifying a laser beam generated by the Master Oscillator section by using the optical fiber, the method including: a voltage detection step of detecting a voltage of a direct-current power supply which supplies an electric current to the Master Oscillator section and the pumping light source; and a control step of carrying out control to open the switch in response to a transition from (i) a state where the voltage detected by the voltage detection section is higher than a predetermined threshold to (ii) a state where the voltage detected by the voltage detection section is lower than the predetermined threshold.

With the above configuration, it is possible to stop the supply of the pumping light from the pumping light source of the PA section to the rare earth element before the supply of the laser beam from the MO section to the PA section is stopped. As a result, it is possible to suppress occurrence of a giant pulse.

### Reference Signs List

1: fiber laser
11: MO section
11a: optical fiber
11b: pumping light source unit
11b1: electric current detection section
11b2: control section
11c: combiner
12: PA section
12a: optical fiber
12b: pumping light source unit
12b1: electric current detection section
12b2: control section
12b3: voltage detection section
12c: combiner

## Claims

1. A fiber laser comprising:
a Master Oscillator section;
a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided within a closed electric current path including the pumping light source and the capacitor, the Power Amplifier section amplifying a laser beam generated by the Master Oscillator section by using the optical fiber;
a voltage detection section which detects a voltage of a direct-current power supply which supplies an electric current to the Master Oscillator section and the pumping light source; and
a control section which carries out control to open the switch in response to a transition from (i) a state where the voltage detected by the voltage detection section is higher than a predetermined threshold to (ii) a state where the voltage detected by the voltage detection section is lower than the predetermined threshold.

2. The fiber laser according to claim 1, wherein:
the Master Oscillator section includes (i) an optical fiber doped with a rare earth element, (ii) a pumping light source which generates pumping light for exciting the rare earth element, and (iii) a capacitor which is connected in parallel with the pumping light source; and
the direct-current power supply supplies an electric current to both the pumping light source included in the Master Oscillator section and the pumping light source included in the Power Amplifier section.

3. The fiber laser according to claim 2, wherein:
a period of time between (i) a point of time when the switch is controlled to be opened and (ii) a point of time when the electric current supplied to the pumping light source included in the Power Amplifier section becomes 0A is not more than 100 µs; and
a period of time between (i) a point of time when the switch is controlled to be opened and (ii) a point of time when the electric current supplied to the pumping light source included in the Master Oscillator section becomes 0A is not less than 1 ms.

4. The fiber laser according to any one of claims 1 to 3, wherein:
the switch is a negative electrode-side switch which is provided on an electric current path between a negative electrode of the direct-current power supply and the pumping light source included in the Master Oscillator section; and
the control section carries out control to open the negative electrode-side switch in response to a transition from (i) a state where the voltage detected by the voltage detection section is higher than the threshold to (ii) a state where the voltage detected by the voltage detection section is lower than the threshold.

5. The fiber laser according to any one of claims 1 to 3, wherein:
the switch comprises
a negative electrode-side switch which is provided on an electric current path between a negative electrode of the direct-current power supply and the pumping light source included in the Master Oscillator section and
a positive electrode-side switch which is provided on an electric current path between a positive electrode of the direct-current power supply and the pumping light source included in the Master Oscillator section; and
the control section carries out control to open one of or both of the negative electrode-side switch and the positive electrode-side switch in response to a transition from (i) a state where the voltage detected by the voltage detection section is higher than the threshold to (ii) a state where the voltage detected by the voltage detection section is lower than the threshold.

6. The fiber laser according to any one of claims 1 to 5, wherein:
the switch is a Field Effect Transistor.

7. A pumping light source unit for use in a fiber amplifier including an optical fiber doped with a rare earth element, the pumping light source unit comprising:
a pumping light source which generates pumping light for exciting the rare earth element;
a capacitor which is connected in parallel with the pumping light source;
a switch which is provided on an electric current path between the pumping light source and the capacitor;
a voltage detection section which detects a voltage of a direct-current power supply which supplies an electric current to the pumping light source; and
a control section which carries out control to open the switch in response to a transition from (i) a state where the voltage detected by the voltage detection section is higher than a predetermined threshold to (ii) a state where the voltage detected by the voltage detection section is lower than the predetermined threshold.

8. A method for controlling a fiber laser that includes a Master Oscillator section and a Power Amplifier section including (i) an optical fiber doped with a rare earth element, (ii) a pumping light source which generates pumping light for exciting the rare earth element, (iii) a capacitor which is connected in parallel with the pumping light source, and (iv) a switch which is provided on an electric current path between the pumping light source and the capacitor, the Power Amplifier section amplifying a laser beam generated by the Master Oscillator section by using the optical fiber, the method comprising:
a voltage detection step of detecting a voltage of a direct-current power supply which supplies an electric current to the Master Oscillator section and the pumping light source; and
a control step of carrying out control to open the switch in response to a transition from (i) a state where the voltage detected in the voltage detection step is higher than a predetermined threshold to (ii) a state where the voltage detected in the voltage detection step is lower than the predetermined threshold.
